Europäisches Patentamt

European Patent Office

Office européen des brevets

(11) Veröffentlichungsnummer: **0 333 117**
**A2**

(12) **EUROPÄISCHE PATENTANMELDUNG**

(21) Anmeldenummer: **89104460.4**

(22) Anmeldetag: **14.03.89**

(51) Int. Cl.⁴: **G03F 7/26**

(30) Priorität: **17.03.88 DE 3808954**

(43) Veröffentlichungstag der Anmeldung:
**20.09.89 Patentblatt 89/38**

(84) Benannte Vertragsstaaten:
**BE DE FR GB IT NL**

(71) Anmelder: **DU PONT DE NEMOURS (DEUTSCHLAND) GMBH**
**Du Pont Strasse 1**
**D-6380 Bad Homburg(DE)**

(72) Erfinder: **Grossa, Mario, Dr.**
**Am Geisberg 21**
**D-6072 Dreieich(DE)**
Erfinder: **Bode, Udo, Dr.**
**Timberlake Apt. F1 P.O. Box 1658**
**Etowah North Carolina 28729(US)**

(54) **Verfahren und Vorrichtung zum Auftragen einer Tonerschicht.**

(57) Es wird ein Verfahren und eine Vorrichtung zum Auftragen einer Tonerschicht (15) von einem Zwischenträger (2) auf eine durch klebrige Bereiche bildmäßig modifizierte Oberfläche eines Trägers (24) angegeben. Der Toner (8) besteht aus einem elektrisch aufladbaren Pulver. Die Oberfläche (3) des Zwischenträgers (2) wird gleichmäßig mit einer Polarität elektrostatisch aufgeladen. Durch Zusammenführen mit Tonerteilchen eines anderen Ladungszustandes wird eine Tonerschicht (15) an der Zwischenträgeroberfläche (3) gebildet und anschließend zumindest auf die klebrigen Bereiche der Trägeroberfläche übertragen. Dies führt zu einer sehr gleichmäßigen Tonerschicht und zu einer sauberen Arbeitsweise.

Fig.1

EP 0 333 117 A2

## Verfahren und Vorrichtung zum Auftragen einer Tonerschicht

Die Erfindung bezieht sich auf ein Verfahren und eine Vorrichtung zum Auftragen einer Tonerschicht von einem Zwischenträger auf eine durch klebrige Bereiche bildmäßig modifizierte Oberfläche eines Trägers.

Bei einem bekannten Verfahren dieser Art (DE-PS 12 05 117) besteht die Oberfläche des Trägers aus einem photopolymersierbaren Material, das durch Belichtung bildmäßig modifiziert wird. Es ergeben sich bei Raumtemperatur oder einer erhöhten Temperatur klebrige Bereiche, an denen ein Toner, der aus Farbstoffen, Tinten, Pigmenten, Farbbildnern, Metallen u. dgl. bestehen kann, haftet, und nicht-klebrige Bereiche, von denen der Toner wieder entfernt werden kann. Diese Trägeroberfläche wird in innige Berührung mit einer die feinverteilten gesonderten Tonerteilchen enthaltenden Schicht gebracht und anschließend abgewischt, so daß sich durch die Färbung der klebrigen Bereiche das gewünschte Bild ergibt. Die Tonerschicht wird zunächst auf eine Walze oder einen anderen Zwischenträger aufgebracht, beispielsweise in Form einer Pigmentdispersion, einer Farbstoffbelegung o.dgl. Stattdessen kann der Toner auch mechanisch, sei es mit einem Wattebausch oder mit einer rotierenden Bürste, unmittelbar auf die Trägeroberfläche aufgebracht werden.

In allen Fällen müssen gewisse Variationen des Tonerauftrags in Kauf genommen werden. Dies führt dazu, daß die klebrigen Bereiche unterschiedlich stark eingefärbt werden. Für viele Anwendungszwecke, beispielsweise für die Herstellung von Farbprüfdrucken nach dem Cromalin-Verfahren der Firma Du Pont de Nemours, ist aber eine möglichst hohe Gleichmäßigkeit erwünscht.

Bei elektrostatischen Fotokopiergeräten ist es bekannt, die aus einer Halbleiterschicht bestehende Oberfläche einer Trommel oder eines sogenannten Masters gleichmäßig elektrostatisch aufzuladen und anschließend durch eine Belichtung bildmäßig zu modifizieren. An den belichteten Stellen fließt die Ladung ab, so daß ein Toner aus elektrostatisch aufladbarem Pulver nach seinem Aufbringen je nach seiner Ladungspolarität an den belichteten oder unbelichteten Stellen haftet. Alsdann wird das so erzeugte Bild auf ein blankes Papier- oder Folienblatt übertragen und dort durch Wärme fixiert.

Des weiteren ist ein Reproduktionsverfahren bekannt, (US-PS 37 62 944), bei dem durch Belichtung eines photopolymerisierbaren und elektrostatisch aufladbaren Harzes mit Wärmestrahlung Bereiche entstehen, die sowohl klebrig als auch in ihrer elektrischen Ladung geändert sind. Anschließend wird ein Toner aufgebracht, der sowohl durch Klebekraft als auch durch elektrostatische Kräfte haftet. Hier wird der Träger unmittelbar mit dem Toner versehen.

Der Erfindung liegt die Aufgabe zugrunde, ein Verfahren der eingangs beschriebenen Art anzugeben, das es erlaubt, eine sehr gleichmäßige Tonerschicht aufzutragen.

Diese Aufgabe wird erfindungsgemäß dadurch gelöst, daß ein Toner aus elektrostatisch aufladbarem Pulver verwendet wird, daß die Oberfläche des Zwischenträgers gleichmäßig mit einer Polarität elektrostatisch aufgeladen und durch ihr Zusammenführen mit Tonerteilchen, die eine Ladung entgegengesetzter Polarität tragen, eine Tonerschicht an der Zwischenträgeroberfläche gebildet wird, und daß diese Tonerschicht zumindest auf die klebrigen Bereiche der Trägeroberfläche übertragen wird.

Der gleichmäßige Ladungszustand der Zwischenträgeroberfläche, der auch noch beim Aufbringen des Toners vorhanden ist, bewirkt, daß auch die Tonerschicht eine sehr gleichmäßige Dikke besitzt. Denn die Ladung der Zwischenträgeroberfläche wird durch die auftreffenden Pulverteilchen mehr und mehr neutralisiert, bis schließlich keine ausreichende Kraft mehr zum Anziehen weiterer Pulverteilchen vorhanden ist. Die gleichmäßige Schicht ergibt sich daher auch schon bei ungleichmäßigem, aber ausreichenden Tonerangebot und erst recht natürlich, wenn übliche Maßnahmen für eine gleichmäßige Tonerzufuhr getroffen werden. Gegenüber den bekannten Verfahren, ein Tonerpulver auf klebrige Bereiche einer Trägeroberfläche aufzubringen, ergibt sich der weitere Vorteil einer großen Sauberkeit. Denn wegen des elektrostatischen Feldes ist ein Entweichen der Pulverteilchen in die Umgebung weitgehend vermieden. Man kann daher auch ein sehr feines Pulver verwenden und daher eine hohe Auflösung des Bildes erreichen.

In vielen Fällen reicht es aus, wenn die Trägeroberfläche mit der Zwischenträgeroberfläche in Berührung gebracht wird, weil dann die klebrigen Bereiche die Toner schicht aufgrund der Klebekraft übernehmen. Besonders günstig ist es aber, wenn die Übertraung unter Zuhilfenahme eines die Tonerteilchen zur Trägeroberfläche hin anziehenden elektrostatischen Feldes erfolgt. Durch dieses elektrostatische Feld wird das Tonerpulver in der vollen Schichtdicke mit großer Sicherheit auf den Träger überführt.

Ein besonders rationelles Verfahren ergibt sich, wenn der Zwischenträger längs einer Bahn bewegt und dabei nacheinander aufgeladen, mit Toner versehen und mit der Trägeroberfläche in Berührung gebracht wird. Alle drei Verfahrensschritte können schnell hintereinander durchgeführt und wiederholt werden.

Eine Vorrichtung zur Durchführung des Verfahrens ist erfindungsgemäß dadurch gekennzeichnet, daß ein Zwischenträger mit elektrostatisch aufladbarer Oberfläche vorgesehen ist, die längs einer ersten Förderbahn bewegbar ist, an der in Bahnrichtung versetzt eine Aufladestation, die eine gleichmäßige elektrostatische Aufladung bewirkt, eine Tonerzuführstation, die der gleichmäßig aufgeladenen Trägeroberfläche über die Breite gleichmäßig Toner zuführt, und eine Übertragungsstation angeordnet ist, und daß für den Träger eine zweite Förderbahn vorgesehen ist, die mit der ersten Förderbahn an der Übertragungsstation zusammentrifft.

Der Zwischenträger kann beispielsweise durch eine Trommel mit einer elektrostatisch aufladbaren Oberfläche gebildet sein. Eine Alternative besteht darin, daß der Zwischenträger durch ein mit einer elektrostatisch aufladbaren Oberfläche versehenes Blatt gebildet ist, das auf einer Trommel aufliegt. Durch die Trommel ist auch die erste Förderbahn vorgegeben.

Die Aufladestation weist zweckmäßigerweise eine Korona-Einheit auf. Durch die Korona-Entladung läßt sich eine sehr gleichmäßige Aufladung erzielen.

Des weiteren ist es günstig, daß die Tonerzuführstation eine drehbare permanentmagnetische Walze aufweist und der Toner mit magnetisierbaren Teilchen vermischt ist. Mit einer solchen bekannten "Magnetbürste" wird der aufgeladenen Zwischenträgeroberfläche eine ausreichende Menge an Tonerpulver angeboten, überschüssiges Pulver aber wieder mit abgeführt.

Mit Vorteil ist an der Übertragungsstation eine die Tonerteilchen zur Trägeroberfläche hin anziehende zweite Korona-Einheit vorgesehen. Diese wird so betrieben, daß sie ein den elektrostatischen Haftkräften entgegenwirkendes elektrostatisches Feld erzeugt. Damit ist sichergestellt, daß die Tonerschicht in gesamter Dicke übertragen wird.

Mit Vorteil ist an der ersten Förderbahn hinter der Übertragungsstation eine Reinigungsstation, die die Zwischenträgeroberfläche vom Toner reinigt, angeordnet. Auf diese Weise hat der Zwischenförderer im neuen Arbeitszyklus eine saubere Oberfläche.

Auch kann an der zweiten Förderbahn hinter der Übertragungsstation eine Reinigungsstation, die die Trägeroberfläche von nicht an klebrigen Bereichen haftendem Toner reinigt, angeordnet sein. Die bildhaft entwickelten Träger kommen daher sauber aus der Vorrichtung heraus.

Die Erfindung wird nachstehend anhand in der Zeichnung dargestellter, bevorzugter Ausführungsbeispiele näher erläutert. Es zeigen:

Fig. 1 eine schematische Darstellung einer erfindungsgemäßen Vorrichtung und

Fig. 2 einen vergrößerten Teilschnitt aus einer abgewandelten Ausführungsform.

Eine Auftragevorrichtung 1 weist eine Trommel 2 aus dielektrischem Material auf, die in Richtung des Pfeiles drehbar ist. Sie bildet einen Zwischenträger mit elektrostatisch aufladbarer Oberfläche 3. Diese Oberfläche bewegt sich längs einer ersten Förderbahn A, nämlich einer Kreisbahn.

Die Oberfläche läuft zunächst an einer Aufladestation 4 vorbei. Diese wird durch eine Korona-Einheit 5 gebildet, die einen sich über die Breite der Trommel 2 erstreckenden dünnen Draht 6 aufweist. Dieser ist an eine negative Gleichspannung von mehreren kV gelegt. Hierdurch wird die Oberfläche 3 gleichmäßig elektrostatisch negativ aufgeladen. Der so gebildeten Auflade-Korona ist ein Draht 6a vorgeschaltet. Er liegt an einer hohen Wechselspannung und dient dem Löschen noch vorhandener Ladungen auf der Oberfläche 3.

In Drehrichtung dahinter folgt eine Toner-Zuführstation 7. Diese weist einen Tonerbehälter 8 mit einer durch einen Schieber 9 einstellbaren Austrittsöffnung 10 auf. Das Tonerpulver fällt auf zwei Mischwalzen 11 und 12, die das Material einer sogenannten "Magnetbürste" 13 zuführen. Diese besteht aus einer rotierenden permanentmagnetischen Walze. Das Tonerpulver ist mit einem Pulver aus magnetisierbarem Material, beispielsweise Eisenfeilspäne, vermischt. Diese stellen sich an der Walze 13 etwa radial, wobei die Tonerteilchen bis an die äußersten Spitzen dieser magnetischen Teilchen wandern. Sie sind im Vergleich zu der Oberflächenladung der Trommel 2 elektrostatisch positiv aufgeladen. Dies geschieht bereits dadurch, daß das Gehäuse der Korona-Einheit 5 und die Magnetwalze 13 an Masse liegen. Spezielle Maßnahmen zur Aufladung der Tonerteilchen sind aber im allgemeinen nicht erforderlich. Ein Abstreifer 14 sorgt für eine etwa gleichmäßige Beladung des Umfangs der Magnetbürste 13 mit Tonerpulver.

Sobald die negativ geladene Oberfläche 3 der Trommel 2 sich der Magnetbürste 13 nähert, werden die positiv geladenen Tonerteilchen zur negativ geladenen Oberfläche 3 hin angezogen. Es ergibt sich eine sehr gleichmäßige Tonerschicht 15 auf der Oberfläche 3.

Eine zweite Förderbahn B ist gestrichelt veranschaulicht. Sie führt von einem Eingabeschlitz 16 durch Transportrollenpaare 17 und 18 hindurch zu einer Übertragungsstation 19, wo sie mit der ersten Förderbahn A zusammentrifft. Sie geht weiter über ein Förderband 20 zu einem Ausgebeschlitz 21. An der Übertragungsstation 19 befindet sich eine zweite Korona-Einheit 22, deren Draht 23 ebenfalls an eine negative Gleichspannung von mehreren kV gelegt ist. Die Polarität ist daher so gewählt, daß sich eine Kraftwirkung auf die Teilchen der Tonerschicht 15 ergibt, welche diese Teilchen zur zweiten Förderbahn B hin anzieht.

Längs dieser Förderbahn B werden Träger 24 geleitet, die eine durch klebrige Bereiche bildmäßig modifizierte Oberfläche besitzen. Diese klebrigen Bereiche entstehen beispielsweise durch Photopolymerisation einer Oberflächenschicht bei Belichtung. Der Durchlauf des Trägers 24 ist mit der Drehung der Trommel 2 synchro nisiert. Wenn der Träger 24 an der Übertragungsstation 19 vorbeiläuft, wird die Tonerschicht 15 auf den Träger 24 übertragen. Die Tonerteilchen haften dann fest an den klebrigen Bereichen.

Eine Reinigungsstation 25 weist eine rotierende Bürste 26, insbesondere einer Faserbürste, auf, die an der Oberfläche 3 der Trommel 2 angreift. Die Oberfläche ist daher für einen neuen Arbeitszyklus gereinigt. Ein Filterkasten 27 nimmt den abgebürsteten Toner auf, beispielsweise in einem Staubbeutel. Ein seitlich angebrachtes Sauggebläse 28 sorgt für die Staubabfuhr von der Bürste 26.

Eine zweite Reinigungsstation 29 weist ebenfalls eine rotierende Bürste 30, insbesondere Faserbürste, auf. Sie reinigt die Oberfläche des Trägers 24 vom Toner, der sich außerhalb der klebrigen Bereiche befindet. Auch hier wird der Tonerrückstand im Filterkasten 27 gesammelt. Der Träger 24 erreicht daher den Ausgangsschlitz 21 mit sauberem Bild.

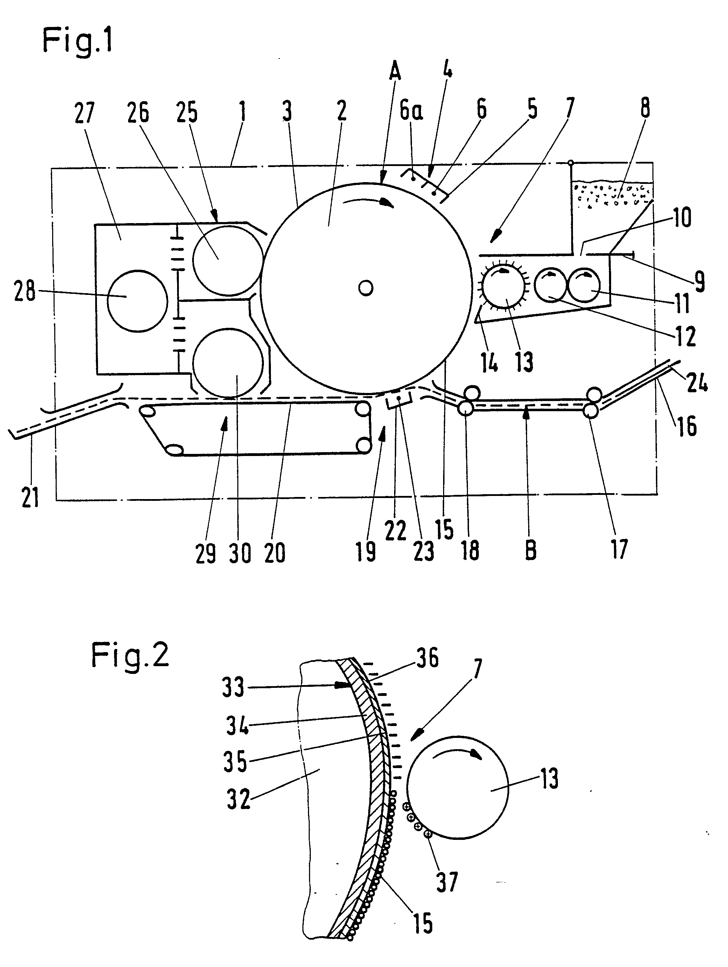

In Fig. 2 ist die Trommel 32 lediglich das Transportmittel für einen Zwischenträger 33, der aus einem Blatt 34 mit einer Schicht 35 aus elektrisch nicht oder schlecht leitendem Material besteht. Die Minus-Zeichen zeigen an, daß die Oberfläche 36 des Zwischenträgers 33 elektrostatisch negativ aufgeladen ist. Die Tonerteilchen 37, die von der Magnetbürste 13 abgegeben werden, sind dagegen positiv aufgeladen, wie das Plus-Zeichen andeutet. Infolgedessen ergibt sich hinter der Tonerzuführstelle 7 die gleichmäßige Tonerschicht 15.

Die Trommel 2 kann aus beliebigem dielektrischen oder halbleitenden Material bestehen. Es genügt auch, wenn lediglich die Oberflächenschicht aus einem solchen Material besteht. Beispielsweise kommt eine vom elektrostatischen Fotokopieren her bekannte Selen-Trommel in Betracht. Auch wenn ein von der Trommel getrennter Zwischenträger 34 benutzt wird, kann man bekannte Materialien wählen, beispielsweise ein Blatt 34 mit einer ZnO-Schicht 35. Da im Gegensatz zum elektrostatischen Fotokopieren die elektrostatisch aufladbare Oberfläche nicht belichtet zu werden braucht, kommen nicht nur lichtempfindliche Halbleiter, sondern auch andere Nicht-und Halbleiter in Betracht, beispielsweise Glas oder organische Kunststoffe wie Polytetrafluorethylen, Polyvinylchlorid, Polystyrol oder auch Mischungen von Pigmenten mit Harzen, wobei sich gezielt ein bestimmter Widerstand einstellen läßt.

Die Toner brauchen nicht notwendigerweise thermoplastisch zu sein, da sie am klebrigen Muster der Trägeroberfläche hinreichend haften und nicht durch Wärmebehandlung fixiert zu werden brauchen. Es können geeignete pigmentierte Kunststoffteilchen aus linearen oder auch vernetzten Polymeren, wie z. B. Polymethylmethacrylat, Celluloseacetat, Polystrol, Polycarbonat oder Polyethylen, verwendet werden. Selbstverständlich sind auch alle für das elektrostatische Fotokopieren oder das elektrostatische Kopieren üblichen Toner geeignet. Bevorzugt wird ein mittlerer Teilchendurchmesser von 1 - 4 $\mu$m, um die hohe Auflösung des klebrigen Musters auszunutzen.

Es empfehlen sich Zwei-Komponenten-Toner, bei denen die zweite Komponente aus einem magnetischen und elektrostatisch aufladbarem Material mit einer Korngröße von etwa 100 $\mu$m besteht. Insbesondere kann es sich um Eisenfeilspäne oder Ferrite handeln.

Die Stärke der Aufladung der Zwischenträgeroberfläche und damit die Dicke der Tonerschicht läßt sich durch eine Änderung der an die Korona-Einheit anzulegenden Spannung oder durch die Einstellung des Spalts zwischen der Korona-Einheit und der Oberfläche ändern.

Vergleicht man vorliegende Vorrichtung mit einem üblichen elektrostatischen Fotokopiergerät, so fehlen die Belichtungseinrichtungen und die Fixierheizung. Der Spalt der Korona-Einheit muß gegebenfalls kleiner eingestellt werden, damit sich die gewünschte Tonerschichtdicke ergibt. Und die Einstellvorrichtung für die Tonerzufuhr sollte, weil die gesamte Fläche beschichtet werden soll, auf maximale Tonerzufuhr eingestellt werden.

Selbstverständlich können die Tonerteilchen auch an einer eigenen Elektrode aufgeladen werden. Man kann die Korona-Einheiten auch an positive Spannung legen und dadurch die Zwischenträgeroberfläche positiv aufladen. Die negative Aufladung wird aber bevorzugt.

Ein elektrophotographischer Entwickler, bestehend aus einem Eisenträger mit 0,8 % schwarzem Toner (komerziell erhältlich bei der Firma APECO), wurde über eine Magnetbürste zuerst auf eine mit -500 V geladene Zinkoxid-Bindemittel-Folie aufgetragen. Die gleichmäßig mit Pulver bedeckte Schicht wurde in Kontakt mit einem bildmäßig belichteten photopolymeren Film vom Typ CROMALIN POSITIV auf Papier gebracht und der Toner unter Anlegung einer Transfercoronaspannung (-600 V) auf den Cromalinfilm übertragen. Der Tonungsschritt wurde viermal wiederholt, anschließend wurde das getonte Bild mit einer rotierenden Faserbürste (oder mit einem weichen Tuch) gereinigt. Man erhielt ein Bild hervorragender Qualität (Auflösung 11 μm Linien, Tonwertumfang 3 - 96 % bei Rasterweite 60/cm).

## Ansprüche

1. Verfahren zum Auftragen einer Tonerschicht von einem Zwischenträger auf eine durch klebrige Bereiche bildmäßig modifizierte Oberfläche eines Trägers, dadurch gekennzeichnet, daß ein Toner aus elektrostatisch aufladbarem Pulver verwendet wird, daß die Oberfläche des Zwischenträgers gleichmäßig mit einer Polarität elektrostatisch aufgeladen und durch ihr Zusammenführen mit Tonerteilchen, die eine Ladung entgegengesetzter Polarität tragen, eine Tonerschicht an der Zwischenträgeroberfläche gebildet wird, und daß diese Tonerschicht zumindest auf die klebrigen Bereiche der Trägeroberfläche übertragen wird.

2. Verfahren nach Anspruch 1, dadurch gekennzeichnet, daß die Übertragung unter Zuhilfenahme eines die Tonerteilchen zur Trägeroberfläche hin anziehenden elektrostatischen Feldes erfolgt.

3. Verfahren nach Anspruch 1 oder 2, dadurch gekennzeichnet, daß der Zwischenträger längs einer Bahn bewegt und dabei nacheinander aufgeladen, mit Toner versehen und mit der Trägeroberfläche in Berührung gebracht wird.

4. Vorrichtung zum Auftragen einer Tonerschicht von einem Zwischenträger auf eine durch klebrige Bereiche bildmäßig modifizierte Oberfläche eines Trägers zur Durchführung des Verfahrens nach einem der Ansprüche 1 bis 3, dadurch gekennzeichnet, daß ein Zwischenträger (2; 33) mit elektrostatisch aufladbarer Oberfläche (3; 36) vorgesehen ist, die längs einer ersten Förderbahn (A) bewegbar ist, an der in Bahnrichtung versetzt eine Aufladestation (4), die eine gleichmäßige elektrostatische Aufladung bewirkt, eine Tonerzuführstation (7), die der gleichmäßig aufgeladenen Trägeroberfläche über die Breite gleichmäßig Toner zuführt, und eine Übertragungsstation (19) angeordnet ist, und daß für den Träger (24) eine zweite Förderbahn (B) vorgesehen ist, die mit der ersten Förderbahn an der Übertragungsstation zusammentrifft.

5. Vorrichtung nach Anspruch 4, dadurch gekennzeichnet, daß der Zwischenträger durch eine Trommel (2) mit einer elektrostatisch aufladbaren Oberfläche (3) gebildet ist.

6. Vorrichtung nach Anspruch 4, dadurch gekennzeichnet, daß der Zwischenträger durch ein mit einer elektrostatisch aufladbaren Oberfläche (36) versehenes Blatt (33) gebildet ist, das auf einer Trommel (32) aufliegt.

7. Vorrichtung nach einem der Ansprüche 4 bis 6, dadurch gekennzeichnet, daß die Aufladestation (4) eine Korona-Einheit (5) aufweist.

8. Vorrichtung nach einem der Ansprüche 4 bis 7, dadurch gekennzeichnet, daß die Tonerzuführstation (7) eine drehbare permanentmagnetische Walze (13) aufweist und der Toner mit magnetisierbaren Teilchen vermischt ist.

9. Vorrichtung nach einem der Ansprüche 4 bis 8, dadurch gekennzeichnet, daß an der Übertragungsstation (19) eine die Tonerteilchen zur Trägeroberfläche (3) hin anziehende zweite Korona-Einheit (22) vorgesehen ist.

10. Vorrichtung nach einem der Ansprüche 4 bis 9, dadurch gekennzeichnet, daß an der ersten Förderbahn (A) hinter der Übertragungsstation (19) eine Reinigungsstation (25), die die Zwischenträgeroberfläche (3) vom Toner reinigt, angeordnet ist.

11. Vorrichtung nach einem der Ansprüche 4 bis 10, dadurch gekennzeichnet, daß an der zweiten Förderbahn (B) hinter der Übertragungsstation (19) eine Reinigungsstation (29), die die Trägeroberfläche von nicht an klebrigen Bereichen haftendem Toner reinigt, angeordnet ist.

EP 0 333 117 A2

Fig.1

Fig.2